# EUROPÄISCHE PATENTSCHRIFT

(11) **EP 3 270 399 B1**
(45) Veröffentlichungstag und Bekanntmachung des Hinweises auf die Patenterteilung: **02.01.2019**
(21) Anmeldenummer: 17000973.2
(22) Anmeldetag: 09.06.2017
(51) Int. Cl.: H01H 11/00, H01H 83/04, G01R 31/327

(54) **TESTVORRICHTUNG ZUM AUTOMATISCHEN ÜBERPRÜFEN DER FUNKTIONSFÄHIGKEIT EINES SCHUTZSCHALTERS**
TEST DEVICE FOR AUTOMATICALLY TESTING THE RELIABILITY OF A CIRCUIT BREAKER
DISPOSITIF D'ESSAI DESTINÉ AU CONTRÔLE AUTOMATIQUE DE LA CAPACITÉ DE FONCTIONNEMENT D'UN DISJONCTEUR

(30) Priorität: 13.07.2016 DE 102016008476
(43) Veröffentlichungstag der Anmeldung: 17.01.2018
(73) Patentinhaber: Langmatz GmbH, 82467 Garmisch-Partenkirchen (DE)
(72) Erfinder: Wulf, Stephan, 82467 Garmisch-Partenkichen (DE)
(74) Vertreter: Flosdorff, Jürgen

(56) Entgegenhaltungen:
- DE-A1-102004 023 202
- DE-U1- 29 519 290
- DE-U1-202014 105 758
- FR-A1- 2 440 609
- GB-A- 2 479 740
- US-A1- 2012 024 677

## Beschreibung

Die Erfindung betrifft eine Testvorrichtung zum automatischen Überprüfen der Funktionsfähigkeit eines elektrischen Schutzschalters, insbesondere eines Fehlerstrom-Schutzschalters (FI-Schalter) oder eines kombinierten Fehlerstrom-Leitungsschutzschalters (FI/LS-Schalter), der eine Prüftaste hat, bei deren Betätigung ein Schalthebel aus einer EIN-Stellung in einer AUS-Stellung umschlägt, in der der zugehörige Stromkreis unterbrochen ist.

Derartige Schutzschalter sind in Niederspannungsverteiler integriert und sorgen für eine Unterbrechung des Stromkreises bei Fehlerstrom zur Erde, um Menschen oder Tiere vor einem Stromschlag zu bewahren.

Die früher FI-Schalter und heute RCD-Schalter genannten Schutzschalter müssen in bestimmten Zeitintervallen, wenigstens alle sechs Monate, auf ihre Funktionsfähigkeit überprüft werden. Die Patentschrift FR 2 440 609 A1 offenbart eine Testvorrichtung zum Überprüfen eines Schutzschalters, die durch das Erzeugen eines Fehlerstroms funktioniert.

Die DE 10 2004 023 202 A1 zeigt ein Prüfgerät zur unterbrechungsfreien Überprüfung eines FI-Schalters. Bisher erfolgt die Funktionsprüfung von Hand, indem eine Bedienungsperson die Prüftaste einwärts drückt, so dass im FI Schalter ein Fehlerstrom simuliert wird, wodurch ein Schalthebel aus der EIN-Stellung in die AUS-Stellung umspringt, wodurch die Funktionsfähigkeit des Schutzschalters festgestellt ist. Nachfolgend muss die Bedienungsperson den Schalthebel wieder gegen Federkraft in die EIN-Stellung zurück verschwenken.

Auf diese Weise überprüft eine Bedienungsperson in der Regel eine Vielzahl von Schutzschaltern, wobei es passieren kann, dass das Zurückstellen des Schalthebels vergessen wird. Dies hat zur Folge, dass hinter dem Schalter befindliche elektrische Systeme stromlos bleiben, wodurch erhebliche Schäden hervorgerufen werden können. Es kommt auch vor, dass zwischen der Auslösung der Prüftaste und der Rückstellung des Schalthebels eine längere Zeitspanne vergeht, z.B. weil eine Bedienungsperson durch äußere Vorgänge wie z.B. ein Telefonat abgelenkt wird, so dass in dieser Zeitspanne die hinter dem Schalter liegenden Verbraucher stromlos bleiben, was dann ebenfalls zu Systemausfällen führt, wenn die in vielen Fällen vorhandene Batteriepufferung für kurze Zeitausfälle überschritten wird.

Der vorliegenden Erfindung liegt die Aufgabe zugrunde, diese Fehlerquelle bei der Überprüfung der Funktionsfähigkeit von Schutzschaltern zu beseitigen.

Diese Aufgabe wird erfindungsgemäß durch die Merkmale des Patentanspruchs 1 gelöst.

Vorteilhafte Ausgestaltungen der Erfindung sind in den Unteransprüchen gekennzeichnet.

Die Erfindung sieht eine automatische Testvorrichtung vor, die bevorzugt dauerhaft an dem Schutzschalter befestigt ist. Die Testvorrichtung hat eine Auslöseeinrichtung für einen Testvorgang, die die Prüftaste des Schutzschalters betätigt, eine Kontakteinrichtung, auf die der Schalthebel, der in die AUS-Stellung umschlägt, auftrifft, wobei die Kontakteinrichtung infolge des Auftreffens ein Kontaktsignal erzeugt, und eine Wiedereinschalt-Einrichtung, die auf das von der Kontakteinrichtung abgegebene Kontaktsignal hin den Schalthebel wieder in die EIN-Stellung zurückstellt.

Diese Vorgänge laufen automatisch in schneller Abfolge ab, angefangen mit einem Startsignal für den Überprüfungsvorgang, dem Empfang eines Kontaktsignals durch das Umschlagen des Schalthebels und der durch das Kontaktsignal hervorgerufenen Rückstellung des Schalthebels mit einem abschließenden Signal für die erfolgreiche Durchführung des Testvorgangs. Der gesamte Testvorgang läuft zuverlässig in kürzester Zeit ab, ohne dass hierfür eine Bedienungsperson erforderlich ist, was mit einer erheblichen Kostenersparnis verbunden ist. Die Rückstellung des Schalthebels und die damit verbundene Zurücksetzung des Schutzschalters in die EIN-Stellung erfolgen zuverlässig. Wegen der geringen Kosten der Überprüfung liegt es nahe, die Prüfzyklen gegenüber dem Stand der Technik beträchtlich zu verringern, was ebenfalls zu einer Erhöhung der Sicherheit beiträgt.

In einer bevorzugten Ausführungsform der Testvorrichtung weist die Auslöseeinheit einen ausfahrbaren Stößel auf, der bei seiner Betätigung auf die Prüftaste auftrifft und diese soweit einwärts drückt, dass hierdurch der Schaltheben betätigt wird. Danach fährt der Stößel wieder in seiner Ausgangsstellung zurück. Der Stößel kann durch einen kleinen Motor bewegt werden oder magnetisch durch eine Spule, wobei alle geeigneten Antriebseinrichtungen verwendbar sind.

Nach einem weiteren Vorschlag kann auch die Wiedereinschalt-Einrichtung einen Stößel aufweisen, der bei seiner Betätigung auf den bevorzugt schwenkbaren, wippartigen Schalthebel auftrifft und diesen bevorzugt gegen Federkraft in die EIN-Stellung zurück drückt. Der Stößel kehrt danach wieder in seine Ausgangslage zurück. Der Stößel kann ebenfalls mechanisch durch einen Motor, magnetisch durch eine Spule oder auf andere Weise vorwärts und rückwärts bewegt werden.

Die Testvorrichtung ist so an dem Schutzschalter angebracht, dass ihre Befestigungslage durch die Bewegungen der Stößel nicht verändert wird. Die Testvorrichtung kann zwei oder mehr Stege aufweisen, die z.B. in Klemmsitzen in Öffnungen des Schutzschalters einsetzbar sind. Die Testvorrichtung kann aber auch auf andere Weise an dem Schutzschalter festgeklemmt oder auf andere Weise befestigt, beispielsweise angeklebt sein. Da die Testvorrichtung nach einem wesentlichen Gesichtspunkt auch zur Nachrüstung bereits vorhandener Schutzschalters geeignet sein soll, ist eine solche Befestigungsart bevorzugt, die keine Veränderung an dem Gehäuse eines bereits eingesetzten Schutzschalters erfordert. Vorzugsweise ist das Gehäuse der Testvorrichtung an dem Gehäuse des Schutzschalters fest geklemmt oder beispielsweise angeklebt.

Mit besonderem Vorteil ist vorgesehen, dass die Testvorrichtung zwei vorstehende, bevorzugt gabelförmige Stege aufweist, die als elektrische Leiter mit einem inneren Stromkreis der Testvorrichtung verbunden sind und die in zwei Öffnungen des Schutzschalters an dessen elektrischen Kontakten fest angeklemmt sind und so den Stromkreis der Testvorrichtung mit Strom versorgen.

Die Testvorrichtung hat nach einem weiteren Vorschlag der Erfindung eine Rechnereinheit mit einer Steuereinrichtung, die mit der Auslöseeinrichtung, der Kontakteinrichtung, der Wiedereinschaltungseinrichtung und einer Sende/Empfangseinrichtung in Verbindung steht und Signale an diese Einrichtungen abgibt bzw. von diesen empfängt. Außerdem hat die Testvorrichtung bevorzugt eine Schnittstelle, an die ein Funkmodul mit der vorstehend angesprochenen Sende-Empfangseinrichtung anschließbar ist, die Signale von einer externen Zentrale empfangen und Signale an die Zentrale abgeben kann.

Außerdem kann die Rechnereinheit ein Zeitmodul aufweisen, so dass mit Datum und Zeitangabe versehene Signale an die Zentrale gesendet werden können, so dass durchgeführte Testvorgänge genau dokumentiert werden können. Ein erfolgreicher Unterbrechungsvorgang des Stromkreises durch Auslösung der Prüftaste des Schutzschalters und das Wiedereinschalten des Stromkreises werden zum Abschluss des Testvorgangs datiert und mit Uhrzeit versehen an die externe Zentrale gemeldet, so dass die Überprüfung der Funktionsfähigkeit des Schutzschalters dokumentiert ist. Dabei versteht es sich, dass auch ein negatives Prüfergebnis auf diese Weise gemeldet wird, wenn nach Betätigung der Prüftaste der Stromkreis nicht unterbrochen wird, oder wenn sich der Schalthebel nicht wieder in die EIN-Stellung zurück bewegen läßt. Ein solches negatives Prüfungsergebnis kann einen entsprechenden Alarm in der externen Zentrale auslösen.

Weitere Einzelheiten der Erfindung ergeben sich aus der nachfolgenden Beschreibung einer Ausführungsform der Testvorrichtung. Dabei zeigen auf rein schematische Weise:
- Figur 1: einen Fehlerstrom-Schutzschalter im EIN-Zustand;
- Figur 2: den Schutzschalter und eine Testvorrichtung im getrennten Zustand;
- Figur 3: die Testvorrichtung und den Schutzschalter im zusammengesetzten Zustand;
- Figur 4: die Testvorrichtung der Figur 3 mit weg gelassenem Gehäuse;
- Figur 5: eine Darstellung ähnlich wie Figur 4 im AUS-Zustand des Schutzschalters;
- Figur 6: den wieder eingeschalteten Zustand des Schutzschalters;
- Figur 7: die Anordnung aus Schutzschalter und Testvorrichtung mit angeschlossenem Funkmodul.

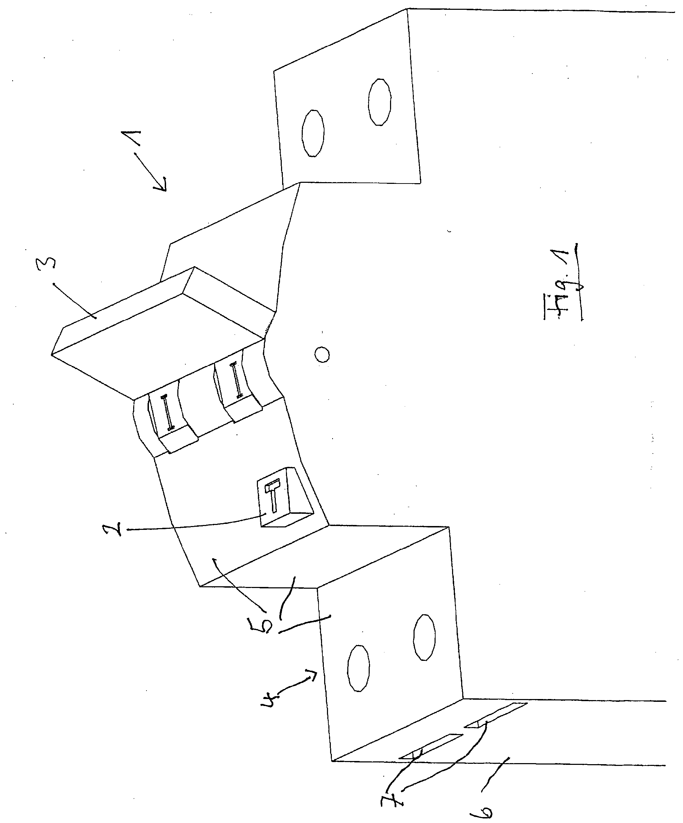

Figur 1 zeigt auf rein schematische Weise die hier interessierenden Bestandteile eines Fehlerstrom-Schutzschalters 1. Der Schutzschalters 1 enthält eine Prüftaste 2 und einen Schalthebel 3, der sich im dargestellten Fall in der EIN-Stellung befindet. Das Gehäuse 4 des Schutzschalters 1 enthält einen stufenförmigen Gehäuseabschnitt 5, an den sich rechtwinklig eine Gehäusewand 6 anschließt, die zwei nebeneinander liegende Schlitze 7 enthält. Hinter den Schlitzen befinden sich zwei elektrische Kontakte.

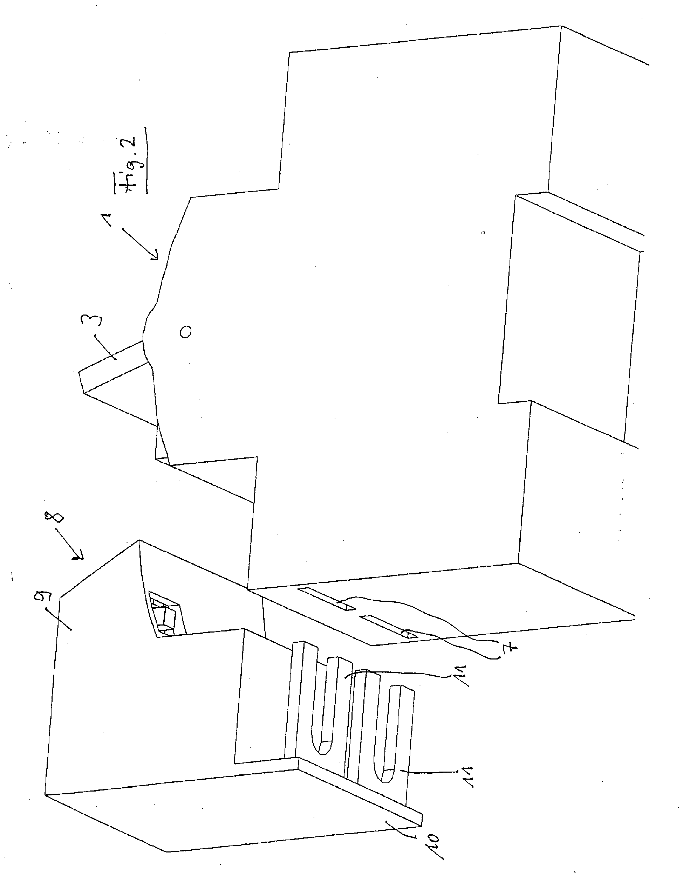

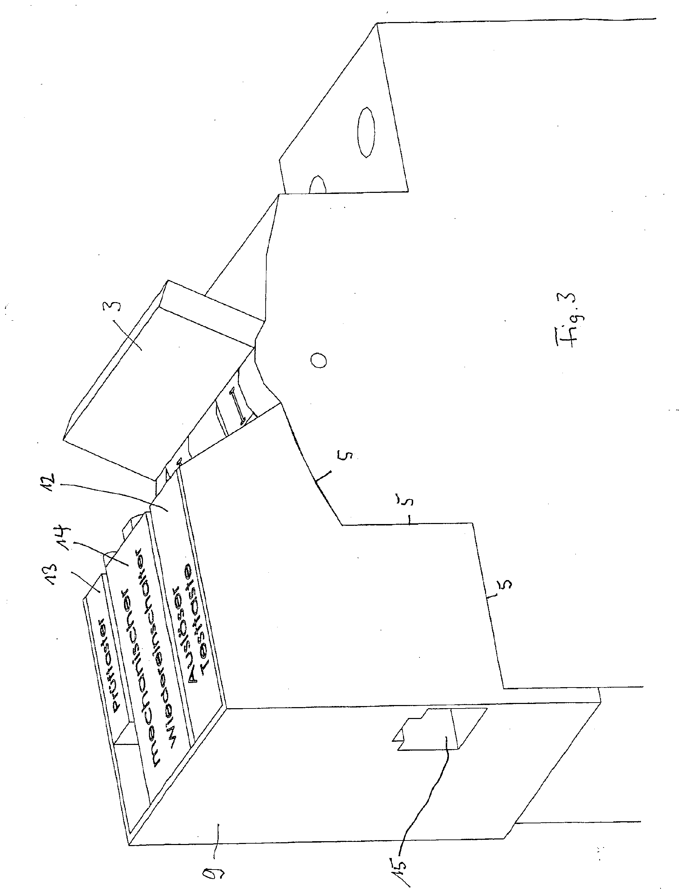

Figur 2 zeigt eine an den Schutzschalter 1 angepasste Testvorrichtung 8, deren Gehäuse 9 eine entsprechend stufenförmig geformte Bodenwand enthält, die passend auf den stufenförmigen Gehäuseabschnitt 5 des Schutzschalters 1 aufsetzbar ist, wie Figur 3 zeigt. Das Gehäuse 9 hat im Anschluss an die stufenförmige Bodenwand 10 einen rechtwinklig sich fortsetzenden Wandabschnitt 10, von dem rechtwinklig zwei gabelförmige Stege 11 abstehen, die als elektrische Leiter ausgebildet sind und sich in das Innere des Gehäuses 9 der Testvorrichtung 8 fortsetzen, um einen inneren Stromkreis der Testvorrichtung mit Strom zu versorgen. Die gabelförmigen Stege 11 passen in die Schlitze 7 und werden an den elektrischen Kontakten hinter den Schlitzen 7 befestigt. Damit ist die Testvorrichtung 8 stabil an dem Schutzschalter 1 befestigt.

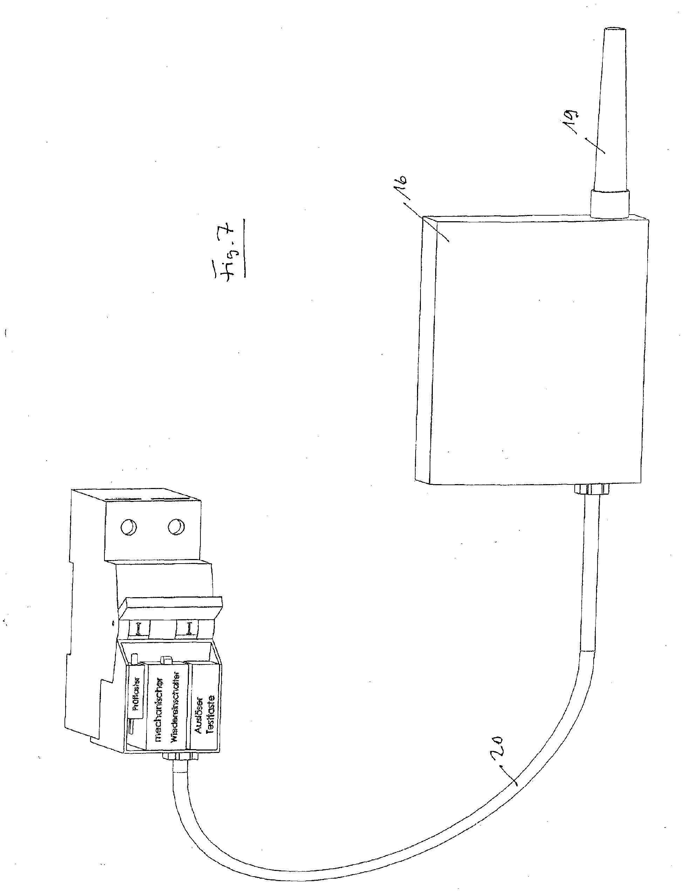

Wie in Figur 3 schematisch angedeutet ist, enthält die Testvorrichtung 8 eine Auslöseeinrichtung 12 für die Prüftaste 2, eine als Prüftaster bezeichnete Kontakteinrichtung 13 und eine Wiedereinschalt-Einrichtung 14. Außerdem enthält das Gehäuse 9 eine seitliche Öffnung 15, in die ein Stecker eines Funkmoduls 16 (Figur 7) einsteckbar ist, wodurch eine Verbindung zwischen dem Funkmodul 16 und einer in dem Gehäuse 9 angeordneten Rechnereinheit herstellbar ist.

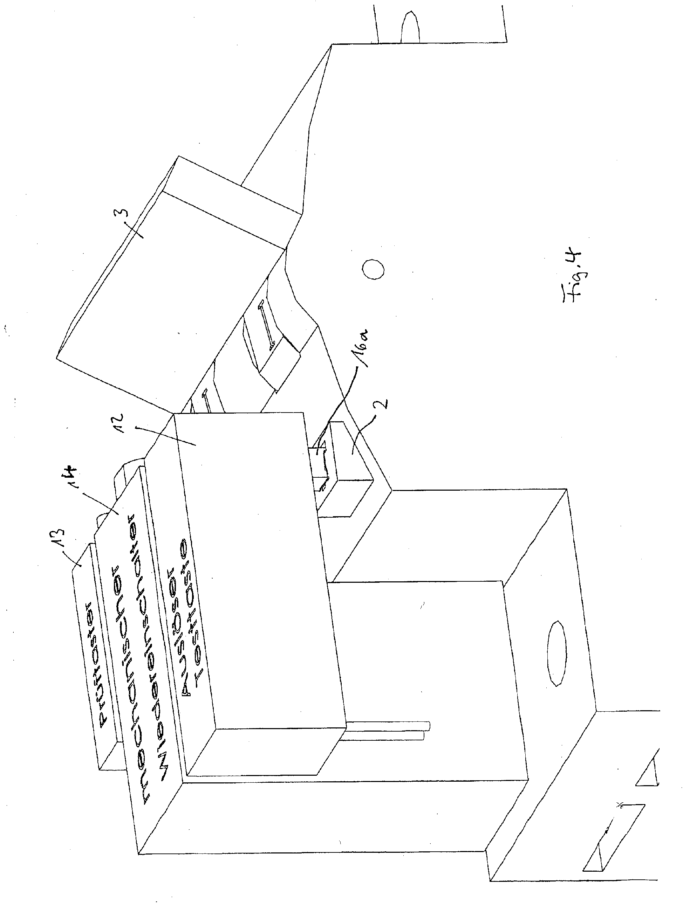

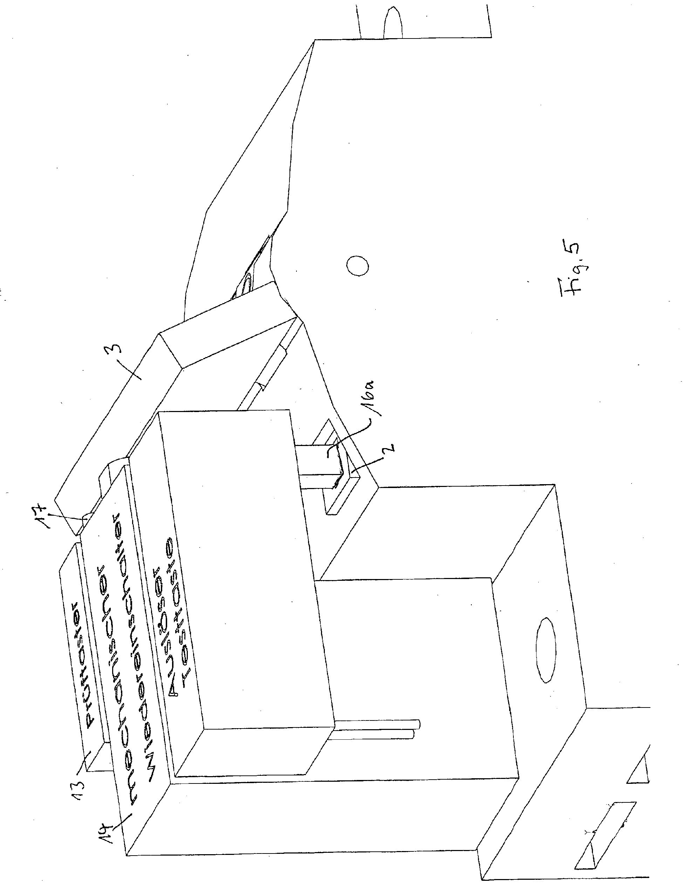

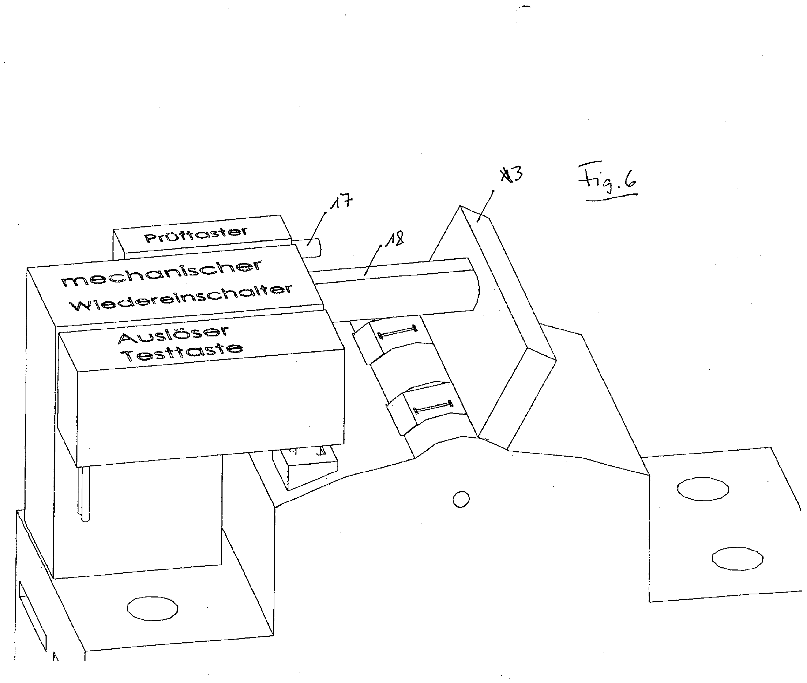

In den Figuren 4 bis 6 ist das Gehäuse 9 der Testvorrichtung 8 weg gelassen, und die Module 12 bis 14 sind rein schematisch dargestellt. Die Auslöseeinrichtung 12 enthält einen in der Befestigungslage auf die Prüftaste 2 ausgerichteten Stößel 16a, der nach unten ausfahrbar ist, um die Prüftaste 2 zu betätigen. Dies hat zur Folge, dass der Schalthebel 3, der durch eine Feder vorgespannt ist, frei gegeben wird und in die AUS-Stellung verschwenkt wird, die in Figur 5 dargestellt ist, wobei der Schalthebel 3 auf ein vorstehendes Kontaktglied 17 der Kontakteinrichtung 13 auftrifft. Dies hat zur Folge, dass die Kontakteinrichtung 13 ein Signal für die Wiedereinschalt-Einrichtung 15 abgibt, die daraufhin einen Stößel 18 ausfährt, der auf den Schalthebel 3 auftrifft und diesen wieder in die EIN-Stellung zurück drückt, wie Figur 6 zeigt.

Wenn ein Prüfvorgang durchgeführt werden soll, gibt eine externe Zentrale ein entsprechendes Signal an das Funkmodul 16, beispielsweise ein GSM-Modem, ab, das das Signal durch seine Antenne 19 empfängt und durch ein in die Öffnung 15 eingestecktes Kabel 20 weiter gibt. Anstelle eines Funkmoduls kann z.B. auch eine leitungsgebundene Signaleinrichtung Verwendung finden. Die Rechnereinheit in der Testvorrichtung 8 leitet das Signal an die Auslöseeinheit 12 weiter.

Wenn der Prüfvorgang abgeschlossen ist, sendet das Funkmodul 16 ein entsprechendes Signal an die externe Zentrale zurück.

Es wird betont, dass die Erfindung nicht auf die beschriebenen und dargestellten Ausführungsformen beschränkt ist, Vielmehr sind alle offenbarten Merkmale auf jede sinnvolle Weise einzeln miteinander kombinierbar. Der Schutzumfang ist aber durch die nachstehenden Ansprüche definiert.

## Patentansprüche

1. Testvorrichtung (8) zum automatischen Überprüfen der Funktionsfähigkeit eines Schutzschalters (1) insbesondere eines Fehlerstrom-Schutzschalters (FI-Schalter) oder eines kombinierten Fehlerstrom-Leitungsschutzschalters (FI/LS-Schalter), der eine Prüftaste (2) hat, bei deren Betätigung im FI-Schalter ein Fehlerstrom simuliert wird, wodurch ein Schalthebel (3) aus einer EIN-Stellung in eine AUS-Stellung versetzt wird, in der der zugehörige Stromkreis unterbrochen ist,
**dadurch gekennzeichnet, dass** die Testvorrichtung (8) sich zur Befestigung an dem Schutzschalter (1) eignet, und dass die Testvorrichtung (8) eine Auslöseeinrichtung (12) zur Betätigung der Prüftaste (2), eine Kontakteinrichtung (13), auf die der Schalthebel (3) in der AUS-Stellung auftrifft, und eine Wiedereinschalt-Einrichtung (14) aufweist, die auf ein Kontaktsignal der Kontakteinrichtung (13) hin den Schalthebel (3) wieder in die EIN-Stellung drückt.

2. Testvorrichtung nach Anspruch 1,
**dadurch gekennzeichnet,**
**dass** die Auslöseeinrichtung (12) einen ausfahrbaren Stößel (16a) aufweist, der bei seiner Betätigung auf die Prüftaste (2) auftrifft und diese einwärts drückt.

3. Testvorrichtung nach Anspruch 1 oder 2,
**dadurch gekennzeichnet,**
**dass** die Wiedereinschalt-Einrichtung (14) einen Stößel (18) aufweist, der bei seiner Betätigung auf den bevorzugt schwenkbaren Schalthebel (3) auftrifft und diesen wieder in die EIN-Stellung zurück schwenkt.

4. Testvorrichtung nach einem der Ansprüche 1 bis 3,
**dadurch gekennzeichnet,**
**dass** die Testvorrichtung Stege (11) aufweist, die in Öffnungen (7) des Schutzschalters einsetzbar sind.

5. Testvorrichtung nach Anspruch 4, **dadurch gekennzeichnet,**
**dass** zwei Stege (11) der Testvorrichtung (8) elektrische Leiter sind, die in zwei Öffnungen (7) des Gehäuses des Schutzschalters (1) an elektrischen Kontakten fest geklemmt sind und einen Stromkreis der Testvorrichtung (8) mit Strom versorgen.

6. Testvorrichtung nach einem der Ansprüche 1 bis 5,
**dadurch gekennzeichnet,**
**dass** die Testvorrichtung (8) eine Rechnereinheit mit einer Steuereinrichtung enthält, die mit der Auslöseeinrichtung (12), der Kontakteinrichtung (13), der Wiedereinschalteinrichtung (14) und einer Sende/Empfangseinrichtung (16) in Verbindung steht.

7. Testvorrichtung nach einem der Ansprüche 1 bis 6,
**dadurch gekennzeichnet,**
**dass** die Testvorrichtung (8) eine Schnittstelle aufweist, an die ein Funkmodul oder eine leitungsgebundene Signaleinrichtung mit der Sende-Empfangseinrichtung (16) anschließbar ist, die Signale von einer externen Zentrale empfangen und Signale an die Zentrale abgeben kann.

8. Testvorrichtung nach Anspruch 6, **dadurch gekennzeichnet,**
**dass** die Rechnereinheit ein Zeitmodul aufweist, so dass mit Datum und Zeitangabe versehene Signale an die Zentrale gesendet werden können.

## Claims

1. Test apparatus (8) for automatically checking the functionality of a protective switch (1), particularly a residual current protective switch (FI circuit breaker) or a combined residual current-line protective switch (FI/LS circuit breaker), which has a test button (2), on actuation of which a residual current is simulated in the Fl circuit breaker, whereby a switch lever (3) is moved out of an ON position into an OFF position, in which the associated circuit is interrupted, **characterised in that** the test apparatus (8) is suitable for fastening to the protective switch (1) and that the test apparatus (8) includes a trigger device (12) for actuating the test button (2), a contact device (13), against which the switch lever (3) impinges in the OFF position, and a switching on device (14), which presses the switch lever (3) into the ON position again in response to a contact signal from the contact device (13).

2. Test apparatus as claimed in Claim 1, **characterised in that** the trigger device (12) includes an extendible pusher (16a), which, when actuated, impinges against the test button (2) and presses it inwards.

3. Test apparatus as claimed in Claim 1 or 2, **characterised in that** the switching on device (14) includes a pusher (18), which, when it is actuated, impinges against the preferably pivotable switch lever (3) and pivots it again back into the ON position.

4. Test apparatus as claimed in one of Claims 1 to 3, **characterised in that** the test apparatus includes webs (11), which are insertable into openings (7) in the protective switch.

5. Test apparatus as claimed in Claim 4, **characterised in that** two webs (11) of the test apparatus (8) are electrical conductors, which are firmly clamped in two openings (7) in the housing of the protective switch (1) to electrical contacts and supply a current circuit of the test apparatus (8) with power.

6. Test apparatus as claimed in one of Claims 1 to 5, **characterised in that** the test apparatus (8) includes a computing unit with a control device, which is connected to the trigger device (12), the contact device (13), the switch on device (14) and a transmitting/receiving device (16).

7. Test apparatus as claimed in one of Claims 1 to 6, **characterised in that** the test apparatus (8) includes an interface to which a radio module or a line-connected signal device with the transmitting/receiving device (16) is connectable, which can receive signals from an external control centre and supply signals to the control centre.

8. Test apparatus as claimed in Claim 6, **characterised in that** the computing unit includes a time module so that signals provided with the date and time information can be transmitted to the control centre.

## Revendications

1. Dispositif de test (8) pour le contrôle automatique de la capacité de fonctionnement d'un disjoncteur (1) en particulier d'un disjoncteur de courant de défaut (disjoncteur FI) ou d'un disjoncteur de ligne de courant de défaut combiné (disjoncteur FI/LS), qui a une touche test (2), lors de l'actionnement de laquelle un courant de défaut est simulé dans le disjoncteur FI, ce par quoi un levier de commutation (3) est déplacé d'une position MARCHE à une position ARRÊT, dans laquelle le circuit électrique afférent est coupé,
**caractérisé en ce que**
le dispositif de test (8) convient à la fixation sur le disjoncteur (1), et
**en ce que** le dispositif de test (8) présente un dispositif de déclenchement (12) pour l'actionnement de la touche test (2), un dispositif de contact (13), que le levier de commutation (3) percute dans la position ARRÊT, et un dispositif de remise en marche (14), qui pousse à nouveau le levier de commutation (3) dans la position MARCHE sur un signal de contact du dispositif de contact (13).

2. Dispositif de test selon la revendication 1,
**caractérisé en ce que**
le dispositif de déclenchement (12) présente un poussoir déployable (16a), qui lors de son actionnement percute la touche test (2) et la pousse vers l'intérieur.

3. Dispositif de test selon la revendication 1 ou 2,
**caractérisé en ce que**
le dispositif de remise en marche (14) présente un poussoir (18), qui lors de son actionnement percute le levier de commutation (3) de préférence pivotant et le fait pivoter à nouveau dans la position MARCHE.

4. Dispositif de test selon l'une quelconque des revendications 1 à 3,
**caractérisé en ce que**
le dispositif de test présente des entretoises (11), qui sont insérables dans des ouvertures (7) du disjoncteur.

5. Dispositif de test selon la revendication 4,
**caractérisé en ce que**
deux entretoises (11) du dispositif de test (8) sont des conducteurs électriques, qui sont fermement serrés dans deux ouvertures (7) du boîtier du disjoncteur (1) au niveau de contacts électriques et alimentent un circuit électrique du dispositif de test (8) en électricité.

6. Dispositif de test selon l'une quelconque des revendications 1 à 5,
**caractérisé en ce que**
le dispositif de test (8) contient une unité de calcul avec un dispositif de commande, qui est connecté au dispositif de déclenchement (12), au dispositif de contact (13), au dispositif de remise en marche (14) et à un dispositif d'émission/réception (16).

7. Dispositif de test selon l'une quelconque des revendications 1 à 6,
**caractérisé en ce que**
le dispositif de test (8) présente une interface, au niveau de laquelle un module radio ou un dispositif de signalisation filaire peut être raccordé au dispositif d'émission-réception (16), qui peut recevoir des signaux d'une centrale externe et envoyer des signaux à la centrale.

8. Dispositif de test selon la revendication 6,
**caractérisé en ce que**
l'unité de calcul présente un module de temps, de sorte que des signaux dotés d'une date et d'une heure puissent être envoyés à la centrale.
